# EUROPÄISCHE PATENTSCHRIFT

(11) **EP 1 244 223 B1**
(45) Veröffentlichungstag und Bekanntmachung des Hinweises auf die Patenterteilung: **30.08.2006**
(21) Anmeldenummer: 02006298.0
(22) Anmeldetag: 20.03.2002
(51) Int. Cl.: H04B 1/38, H05K 9/00

(54) **Drahtloses Telefon mit EMV-Abschirmung**
Wireless telephone with EMI shielding
Telephone sans fil avec blindage EMI

(30) Priorität: 22.03.2001 DE 10114004; 06.07.2001 DE 10132881
(43) Veröffentlichungstag der Anmeldung: 25.09.2002
(73) Patentinhaber: König, Florian Meinhard, 82110 Germering (DE)
(72) Erfinder: König, Florian Meinhard, 82110 Germering (DE)
(74) Vertreter: Englaender, Klaus

(56) Entgegenhaltungen:
- EP-A- 0 949 052
- US-A- 5 374 779
- US-A- 5 731 963
- US-A- 5 938 979

## Beschreibung

Die Erfindung betrifft einen drahtlosen Telefon-Hör-/SprechapparaL insbesondere ein Funktelefon bzw. ein Handy, ein schnurloses Telefon oder dgl., mit einer Oberschale, die Durchbrüche für Bedienelemente enthält, mit einer Unterschale und mit einem elektrisch leitenden Abschirmelement zum Abschirmen von durch Elektronik dieses Apparats erzeueter EMV-Strahlung.

Ein derartiger, aus der EP 0 633 585 A1 bekannter Apparat ist als Handtelefon ausgelegt, dessen Oberschale innenseitig mit einem Abschirmelement in Gestalt eines elektrisch leitenden Metallblechs ausgekleidet ist.

Der Erfinder der vorliegenden Anmeldung hat in zahlreichen Messreihen ermittelt, dass Handys, aber auch schnurlose Telefone erhebliche Störstrahlung emittieren und der aus der EP 0 633 585 A1 bekannte Apparat nicht geeignet ist, die auftretende Störstrahlung ausreichend zu unterdrücken. Typischerweise liegt diese Störstrahlung in einem Frequenzbereich unter einigen Giga-Hertz. Die Intensität dieser Störstrahlung beträgt einige Watt für ein typisches Handy. Diese Störstrahlung ist deshalb besonders bedenklich, weil der in Rede stehende Telefon-Hör-/Sprechapparat im unmittelbaren Schläfenbereich eines Nutzers zum Einsatz gelangt. Es besteht deshalb ein dringender Bedarf, diesen Nachteil herkömmlicher Apparate der in Rede stehenden Art zu überwinden.

Aus der US-A-5374779 ist ein Aufbau zum Abschirmen elektromagnetischer Wellen bekannt. Dieser Aufbau, der beispielsweise im Zusammenhang mit Funkgeräten, die im UKW-Wellenbereich arbeiten, zum Einsatz kommt, umfasst Abschirmmaterial in Gestalt magnetischer leitender Folien.

Eine Aufgabe der vorliegenden Erfindung besteht darin, einen drahtlosen Telefon-Hör /Sprechapparat zu schaffen, der zumindest beim bestimmungsgemäßen Einsatz am Ohr eines Nutzers in Richtung Kopf, insbesondere Schläfe des Nutzers zumindest deutlich weniger nieder- und/oder hochfrequente Störstrahlung emittiert als Apparate gemäß dem Stand der Technik.

Gelöst wird diese Aufgabe durch die Merkmale des Anspruchs 1. Vorteilhafte Weiterbildungen der Erfindung sind in den Unteransprüchen angegeben.

Die erfindungs gemäß vorgesehene Einrichtung zum Anlegen eines Gegenfelds mit nieder- und/oder hochfrequenten Feldanteilen dicert zum zumindest teilweisen Auslöschen des von der Elektronik des Apparates erzeugten elektromagnetischen Felds, wobei diese Einrichtung an das Metallblech der Oberschale und/oder der Unterschale und/oder des Antennenstummels bzw. der Antenne angekoppelt ist, um den Feldanteil der Sprechapparat-Energieabstrahlung in Richtung zum Kopf eines Nutzers deutlich zu reduzieren. Diese elektronische Abschirmmaßnahme ist nachrichtentechnisch gleichzustellen mit einer Maßnahme zur Änderung der Richtwirkung der Sende-/Empfangsantenne in der Ausführung, dass die Schläfenseite des Apparats (Bedienelementseite des Telefons/Handys) als hochfrequenzstrahlungsärmste Zone ausgebildet ist.

Das erfindungsgemäße Abschirmelement kann unterschiedlichen Aufbau besitzen. Gemäß einer besonders bevorzugten Variante enthält das Abschirmelement einen Material-Verbund aus elektrisch leitendem Material und magnetisch leitendem Material. Dieser Verbund kann ein elektrisch leitendes Blech und ein magnetisch leitendes Blech umfassen. Als magnetisch leitendes Blech kommt vor allem MU-Blech in Betracht. Alternativ zu einem Verbund aus zwei Metallblechen kann auch ein elektrisch leitendes Metallblech, vor allem ein MU-Blech mit einer elektrisch leitenden Metallbeschichtung vorgesehen sein, um das erfindungsgemäße Abschirmelement zu bilden. Das jeweilige Blech kann ferner entweder massiv oder durchbrochen bzw. perforiert oder netzartig gebildet sein. Dieses Material zeichnet sich durch geringes Gewicht aus und eignet sich besonders gut zur Einbettung im Kunststoffmaterial der Ober- und Unterschale oder zur Auskleidung deren Innenseite.

Das erfindungsgemäße Abschirmelement kann in unterschiedlicher Gestalt vorliegen. Beispielsweise liegt im Umfang der Erfindung, elektromagnetische Strahlung emittierende Apparatebestandteile, beispielsweise den HF-Sende-/Empfängerteil mit Abschirmmaterial gezielt zu verkapseln. Alternativ oder ergänzend kann das Abschirmelement als größerflächiges Abschirmelement an der Innenseite der Ober- und/oder Unterschale zumindest als partielle Auskleidung vorgesehen sein oder zumindest eine dieser Schalen kann integral mit einem solchen Schirmelement aus EMV-Abschirmmaterial gebildet sein.

MU-Metallblech bildet eine bevorzugte Ausgangsbasis für die unterschiedlichen Ausführungsformen des erfindungsgemäßen EMV-Abschirmelements.

Gemäß einer vorteilhaften Weiterbildung der Erfindung kann der üblicherweise mit einer Kunststoffhülle verkleidete übliche Antennenstummel bzw. allgemein ein Antennenelement, das auch im Innern des Schalengehäuses des Apparats vorgesehen sein kann, des drahtlosen Telefon-Hör-/Sprechapparats in die erfindungsgemäße EMV-Abschirmmaßnahme einbezogen sein. Zu diesem Zweck ist vorteilhafterweise vorgesehen, dass die Antennenverkleidung zur Strahlungsabschirmung des Kopfes eines Nutzers das Material des erfindungsgemäßen Abschirmelements, z.B. MU-Metallblech umfasst, welches den Antennenstummel zumindest kopfseitig soweit abdeckt, dass kopfabgewandt die Antennenfunktion gewährleistet ist, während kopfzugewandt eine effektive EMV-Abschirmung bereitgestellt ist.

Eine bevorzugte Ausführungsform dieser Variante sieht vor, dass das EMV-Abschirmelement zur Abschirmung der Antennenverkleidung allgemeine U-Form mit parallel zum Antennenstummel verlaufenden U-Schenkeln besitzt, die einen kopfabgewandten Abstrahl-Empfangswinkel der Antenne im Bereich von mindestens 90° bis etwa 170° gewährleistet.

Aber auch eine vollständig im Gehäuse angeordnete bzw. in diese integrierte Antenne kann in die erfindungsgemäße EMV-Abschirmmaßnahme einbezogen sein. Zu diesem Zweck ist vorteilhafterweise vorgesehen, dass die Antenne zur EMV-Abschirmung des Kopfes eines Nutzers das erfindungsgemäße Abschirmelement, z.B. MU-Metallblech umfasst, welches die Antenne kopfseitig soweit abdeckt, dass kopfabgewandt die Antennenfunktion gewährleistet ist, während kopfzugewandt optimale EMV-Abschirmung besteht.

Vorteilhafterweise umfasst die Einrichtung zum Anlegen eines elektromagnetischen Gegenfelds eine Signalerzeugungs- und/oder Zufuhreinheit zur Erzeugung eines elektromagnetischen Gegenfelds, die über mindestens eine λ/x-Miniatur-Dipolantenne (x steht für eine ganze positive Zahl) an das MU-Metallblech gekoppelt/angebracht/beaufschlagt ist.

Vorteilhaftenveise umfasst die Einrichtung zum Anlegen eines elektromagnetischen Gegenfelds eine besagte alx-Miniatur-Dipolantenne enthaltende Meß- und Regelschleife mit einer Sonde zum Messen des von der Elektronik des Apparates erzeugten Magnetfelds. Hierdurch wird eine an die aktuelle Leistung dieser Elektronik angepasste, aktive (nicht passive) elektronisch sich ausregelnde Abschirmmaßnahme bereitgestellt.

Optimiert wird diese Regelschleifenanordnung dadurch, dass die Signalerzeugungs- und Zuführeinheit mit der Meß- und Regelschleife über eine Signalprozessoreinheit verknüpft ist. Diese Verknüpfung umfasst bevorzugt ein Mittel zur Signal-/Phasensynchronisation, und dieses Mittel stellt vorteilhafterweise zur Signalpaket-/Phasensynchronisation eine Phasendrehung der Signale um 180°.

Nachfolgend wird die Erfindung anhand der Zeichnungen beispielhaft näher erläutert; es zeigen:
- Fig. 1: ein erfindungsgemäß mit einer EMV-Abschirmung in Gestalt eines mit einem elektrisch und magnetisch leitendem Metallblechverbund-Gehäuse versehenes Handy,
- Fig. 2: den Handapparat eines schnurlosen Telefons, mit einem geschirmten Gehäuse gemäß Fig. 1 und zusätzlich mit einer elektronischen Abschirmmaßnahme in Gestalt einer Einrichtung zur Gegenfelderzeugung,
- Fig. 3: in Diagrammform den zeitlichen Verlauf der Amplitude des vom Handapparat bzw. Handy gemäß Fig. 1 und 2 erzeugten elektromagnetischen Felds und den zeitlichen Verlauf der Amplitude des erfindungsgemäßen daran angelegten elektromagnetischen Gegenfelds, und
- Fig. 4: einen Querschnitt der Unterschale des Gehäuses von Fig. 1 zur Erläuterung seines Aufbaus aus einem elektrisch und magnetisch leitenden Metallblechverbund.

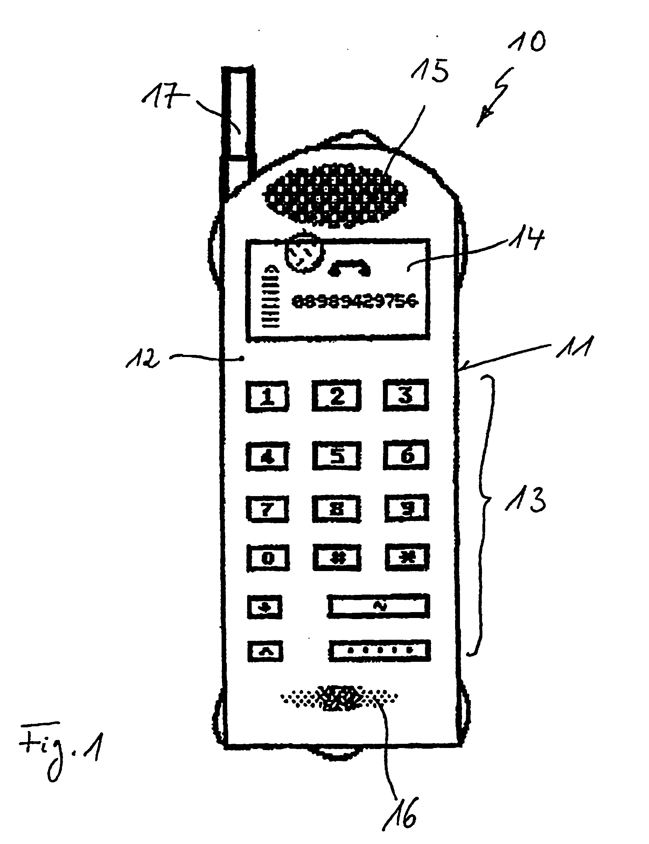

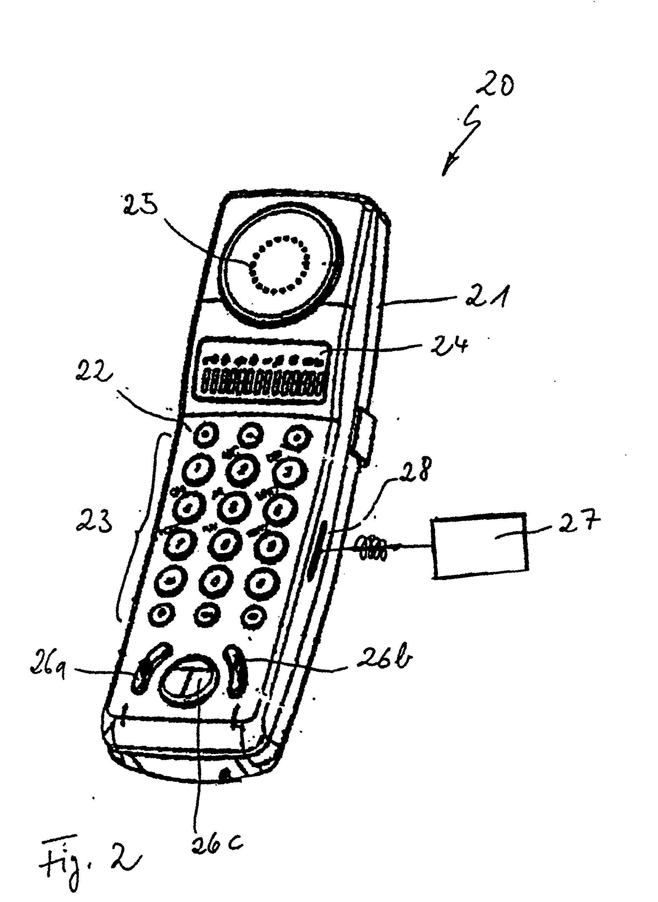

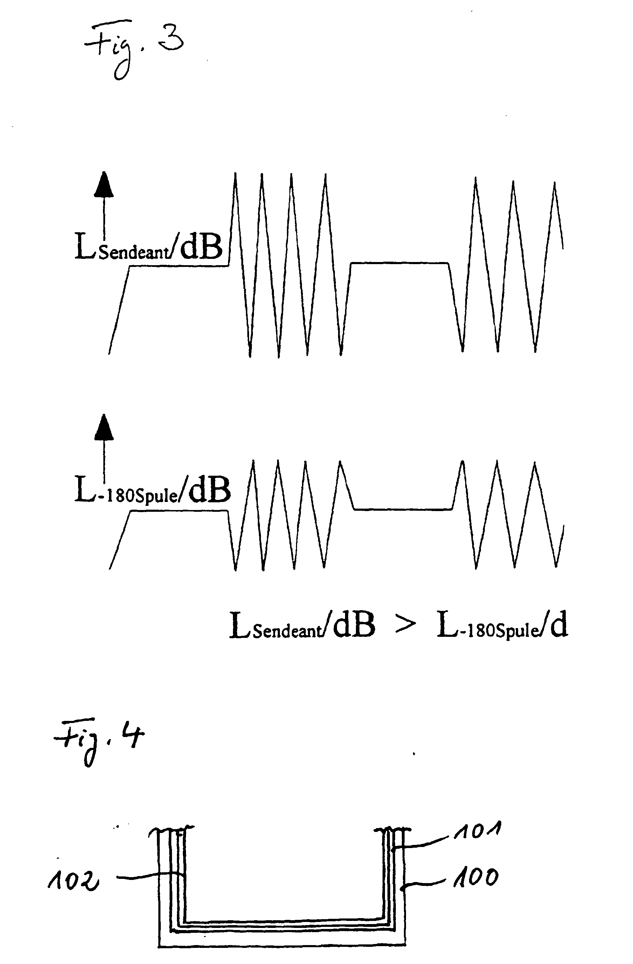

Das in Fig. 1 allgemein mit der Bezugsziffer 10 bezeichnete Handy stellt ein Beispiel des in Rede stehenden Telefon-Hör-/Sprechapparats dar. Das Handy 10 umfasst ein Gehäuse 11 mit einer Oberschale 12 und mit einer in Fig. 1 nicht gezeigten Unterschale (s. Unterschale 21 des schnurlosen Telefons gemäß Fig. 2 bzw. Querschnittansicht gemäß Fig. 4). In der Oberschale 12 befinden sich zahlreiche Ausnehmungen bzw. Durchbrüche für verschiedene Elemente, beispielsweise einer Tastatur mit unterschiedlichen Tasten, u.a. einer Zehnertastatur für Wählzwecke bzw. zur Befehls- oder Dateneingabe, wobei die Tastatur insgesamt mit der Bezugsziffer 13 bezeichnet ist. Über der Tastatur 13 ist ein rechteckiger Durchbruch für ein Display 14 vorgesehen. Über dem Display 14 sind rasterartige Durchbrüche 15 für einen unter der Oberschale 12 angeordneten Lautsprecher vorgesehen. Das Pendant dieser rasterartigen Durchbrüche befindet sich unterhalb der Tastatur 13 in Gestalt rasterartiger Durchbrüche 16 für zumindest ein Sprechmikrophon.

Das in Fig. 1 gezeigte Handy 10 umfasst außerdem eine Antenne in Gestalt eines Antennenstummels, welcher mit einer Kunststoffhülse 17 verkleidet ist.

Erfindungsgemäß ist zumindest diejenige Seite des Gehäuses 11, die bei bestimmungsgemäßem Einsatz des Handys 10 am Schläfenbereich des Kopfes eines Nutzers zu liegen kommt, beim Handy 10 gemäß Fig. 1 die Oberschale 12 des Handys 10 speziell zur elektromagnetischen Feldabschirmung gebildet. In den in Fig. 1, 2 und 4 gezeigten Ausführungsformen sind Ober- und Unterschale des Gehäuses 11 durchgehend aus elektrisch und magnetisch leitendem Material gebildet. Wie in Fig. 4 anhand einer Unterschale 100 gezeigt, besteht diese (ebenso wie beispielsweise bei der Oberschale) aus einem Verbund aus einem elektrisch leitenden Blech 101 und einem magnetisch leitenden Blech 102, wie etwa MU-Blech.

Alternativ kann z.B. die Oberschale 12 wie bislang üblich aus Kunststoff bestehen und innenliegend mit dem elektrisch und magnetisch leitenden Abschirmmaterial zumindest teilweise in den Bereichen ausgekleidet sein, welche durch Messen leicht ermittelbar besonders stark elektrische/magnetische Strahlung emittieren. Um auch diese Maßnahme nachrüstbar zu gestalten, ist beispielsweise die aus Kunststoff bestehende Oberschale dünner gebildet als üblich, und die restliche zur Verfügung stehende Dicke der Oberschale ist mit MU-Metallblech zumindest teilweise verkleidet. Der Antennenstummel ist erfindungsgemäß ebenfalls in die elektrische/magnetische Abschirmmaßnahme mit einbezogen. Erreicht wird dies beispielsweise dadurch, dass die Hülse 17 des Antennenstummels zumindest auf der zum Ohr eines Nutzers weisenden Seite mit MU-Blech verkleidet ist. Der entsprechende Verkleidungshülsenteil hat allgemeine U-Form mit parallel zum Antennenstummel bzw. zu seiner Verkleidungshülse 17 verlaufenden U-Schenkeln, die einen kopf abgewandten Abstrahl-Empfangswinkel der Antenne im Bereich von mindestens 90° bis etwa 170° gewährleistet. Diese die Antenne des Handys betreffende Abschirmmaßnahme kann auch im Fall einer Antenne angewendet werden, die in das Gehäuse 11 des Handys 10 integriert ist.

Fig. 2 zeigt eine Variante des in Rede stehenden drahtlosen Telefon-Hör/Sprechapparats in Gestalt des Hör-/Sprechapparats eines schnurlosen Telefons. Dieser allgemein mit der Bezugsziffer 20 bezeichnete Hör-/Sprechapparat besitzt einen ähnlichen Aufbau wie der in Fig. 1 gezeigte Apparat mit einer Unterschale 21, einer Oberschale 22 und zahlreichen Durchbrüchen für eine Tastatur 23 und ein Display 24. Außerdem sind im oberen Bereich der Telefongehäuses in der Oberschale 22 im Kreis angeordnete rasterartig verteilte Durchbrüche 25 für den Hindurchtritt von Schall eines dort angeordneten Lautsprechers vorgesehen. Für da Mikrophon befinden sich Durchbrüche 26a, 26b und 26c am unteren Ende der Oberschale 22.

Die Oberschale 22 ist in ähnlicher Weise mit MU-Metallblech ausgekleidet oder besteht aus diesem Material wie bei dem Apparat von Fig. 1. Außerdem ist die nicht dargestellte, beispielsweise innerhalb des Gehäuses zu liegend kommende Antenne entsprechend mit MU-Metallblech in Richtung zum Kopf eines Nutzers zugewandten Vorderseite des Apparats 20 mit MU-Metallblech verkleidet, ohne Empfang/Abstrahlung der Antenne zu behindern.

Zusätzlich zu der auf MU-Metallblech basierenden Abschirmmaßnahme bzw. der entsprechenden Abschirmmaßnahmen ist bei der Ausführungsform des Apparats von Fig. 2 eine aktive (höchstfrequente) elektronische Feldabschirmmaßnahme in Gestalt mindestens einer Einrichtung 27 zum Anlegen eines elektromagnetischen Gegenfelds an das Metallblech der Oberschale 22 vorgesehen, um zumindest teilweise das von der Elektronik des Apparats 20 erzeugte elektromagnetische Feld zu kompensieren. Die Einrichtung 27 ist schematisch außerhalb des Gehäuses bzw. der Ober- und Unterschale des Gehäuses gezeigt, jedoch in einer praxisgerechten Ausführungsform in den Apparat 22 auf der Gehäuseoberfläche integriert, und sie umfasst eine Signalerfassungs-/erzeugungs- und/oder Zuführeinheit, die im einzelnen nicht gezeigt ist, und die zur Erzeugung des elektromagnetischen Gegenfelds dient sowie über mindestens eine isolierte, λ/x-Miniatur-Dipolantenne 28 an das MU-Metallblech gekoppelt/angebracht/beaufschlagt ist.

Die Einrichtung 27 zum Anlegen eines elektromagnetischen Gegenfelds umfasst (ebenfalls nicht gezeigt) eine Meß- und Regelschleife für die Signalerzeugungs- und Zufuhreinheit mit einer Signalprozessoreinheit zum Verknüpfen der Signalerzeugungs- und Zufuhreinheit mit der Meß- und Regelschleife. Die Verknüpfung dieser beiden Einheiten umfasst bevorzugt ein Mittel zur Signalpaket-/Phasensynchronisation, das bevorzugt eine Phasendrehung des Signalpakets um 180° bereitstellt. Hierdurch wird der standardisiert vorgegebenen Pulsung (GSM, UMTS) der Sprachsignalpakete von 100 Hz (DECT-Pulsung) im Fall eines schnurlosen Telefons bzw. 217 Hz im Fall eines Handys (900 oder 1800 MHz) Rechnung getragen. Diese Signalpakete werden über vorzugsweise mehrere λ/x-Miniatur-Dipolantennen 28 phasengedreht an das MU-Metallblech von beispielsweise der Oberschale in dieses Blech eingespeist. Dies kann beispielsweise derart erfolgen, dass ein Teil der mit dem 900-MHz-Träger aufmodulierten Signalpakete angezapft wird und phasengedreht in die λ/x-Miniatur-Dipolantenne 28 eingespeist wird. Diese Einspeisung erfolgt jedoch intensitätsreduziert, damit bei Überlappung der Antennenfeldsignalamplituden von Nutzsignal und Kompensations-Auslöschsignal eine möglichst vollständige Amplitudenauslöschung kopfnahe bereitgestellt wird, wie dem Fachmann an sich bekannt, weshalb vorliegend auf Einzelheiten nicht eingegangen werden muß.

Das gegebenenfalls die obere Schale eines Handys bildende MU-Metallblech (siehe Fig. 1 und 2) wird zugunsten der vorstehend erläuterten Abschirmmaßnahme beaufschlagt mit einem elektromagnetischen Gegenfeld, dessen Phasenlage um 180° gedreht ist zu dem elektromagnetischen Feld, welches von dem Handy abgestrahlt wird. Mit anderen Worten bildet das MU-Metallblech zusammen mit der λ/x-Sendeantenne bzw. mehreren derartigen Antennen zum Anlegen von elektromagnetischen Gegenfeldern eine relativ großflächige Hochfrequenz-Sendeantenne. Diese Sendeantenne wird mit einem schwachen Höchstfrequenz- bzw. Hochfrequenz-Kompensationssignal zur Erzeugung des elektromagnetischen Gegenfelds über die Einrichtung 27 versorgt. Gemäß einer vorteilhaften Weiterbildung wird diese großflächige Sendeantenne zusammen mit der bzw. den λ/x-Antenne(n) in der Einrichtung 27 einer Signalleistungserfassung unterzogen. Die dabei erfassten Teilsignalintensitäten der diversen Antennen bildet Grundlage für ein in der Einrichtung 27 zu erzeugendes Kompensations-Hochfrequenz-Sendesignal (elektromagnetisches Gegenfeld), das an die jeweiligen Antennen angelegt wird, so dass sich an der Schläfe des das Handy nutzenden Nutzers über die Fläche gesehen ein Hochfrequenzsignal-Leistungsminimum in einem zeitlichen Rahmen von Millisekunden bis Sekunden ausregelt. Diese Ausregelung basiert auf Feldlinien unterschiedlicher Intensität an unterschiedlichen Positionen des Handys bzw. der Schläfe eines Nutzers.

Wenn beispielsweise das Handy mit einer Freisprecheinrichtung, welche der Nutzer in einer Hand hält, betrieben wird, ergeben sich unterschiedliche Regelungsvorgänge, die jedoch stets zur Tastaturseite des Handys hin mit minimaler Hochfrequenzsignalintensität erfolgen. Im Wellenlängen-Nahfeldbereich ergibt sich eine Vermischung bzw. Überlappung von Feldern der unterschiedlichen Sendeantennen, wobei die großflächige Sendeantenne in Gestalt des MU-Metallblechs den größten Anteil im Hinblick auf die Richtcharakteristik hat.

## Patentansprüche

1. Drahtloser Telefon-Hör-/Sprechapparat, insbesondere Funktelefon bzw. Handy (10), schnurloses Telefon (20) oder dgl., mit einer Oberschale (12, 22), die Durchbrüche für Bedienelemente (13, 23) enthält, mit einer Unterschale (21) und mit einem elektrisch leitenden Abschirmelement (100) zum Abschirmen von durch Elektronik dieses Apparats erzeugter EMV-Strahlung, **dadurch gekennzeichnet, dass** das Abschirmelement (100) zur Abschirmung von HF- und/oder NF-Strahlung außerdem magnetisch leitend ist, und
dass mindestens eine Einrichtung (27) zum Anlegen eines Gegenfelds mit nieder- und/oder hochfrequenten Feldanteilen zum zumindest teilweisen Auslöschen des von der Elektronik des Apparates erzeugten Felds an das Abschirmelement (100) vorgesehen ist, um den Feldanteil der Sprechapparat-Energieabstrahlung in Richtung auf den Kopf eines Nutzers zusätzlich zu reduzieren.

2. Drahtloser Telefon-Hör-/Sprechapparat nach Anspruch 1, **dadurch gekennzeichnet, dass** die Einrichtung (27) eine Signalerfassungserzeugungs- und - zufuhreinheit zur Erzeugung eines elektromagnetischen Gegenfelds umfasst, die über mindestens eine isolierte λ/x-Miniatur-Dipolantenne (28) an das MU-Metallblech ein- oder beidseitig gekoppelt ist (x ist eine ganze positive Zahl).

3. Drahtloser Telefon-Hör-/Sprechapparat nach Anspruch 1 oder 2, **dadurch gekennzeichnet, dass** die Einrichtung eine die λ/x-Miniatur-Dipolantenne (28) enthaltende Mess- und Regelschleife mit einer Sonde bzw. Antenne zum Messen des von der Elektronik des Apparates kopfzugewandt resultierenden erzeugten elektromagnetischen Gesamtfelds umfasst.

4. Drahtloser Telefon-Hör-/Sprechapparat nach Anspruch 2 oder 3, **dadurch gekennzeichnet, dass** die Signalerzeugungs- und -zufuhreinheit mit der Mess- und Regelschleife über eine Signalprozessoreinheii verknüpft ist.

5. Drahtloser Telefon-Hör-/Sprechapparat nach Anspruch 4, **dadurch gekennzeichnet, dass** die Verknüpfung der beiden Einheiten ein Mittel zur höchstfrequenten Signal-/Phasensynchronisation umfasst.

6. Drahtloser Telefon-Hör-/Sprechapparat nach Anspruch 5, **dadurch gekennzeichnet, dass** das Mittel zur Signalpaket-/Phasensynchronisation eine Phasendrehung der höchstfrequenten Signale um 180 Grad für das Gegenfeld bereitstellt.

7. Drahtloser Telefon-Hör-/Sprechapparat nach einem der Ansprüche 2 bis 6, **dadurch gekennzeichnet, dass** die Steuereinrichtung (27) das MU-Metallblech als großflächige Sendeantennen bei der Erzeugung des elektromagnetischen Gegenfelds berücksichtigt.

8. Drahtloser Telefon-Hör-/Sprechapparat nach Anspruch 6, **dadurch gekennzeichnet, dass** die Einrichtung (27) zusätzlich zu der großflächigen Antenne die λ/x-Miniatur-Dipolantenne (28) zu gegebenenfalls einer Vielzahl derartiger Dipolantennen mit in die Erzeugung des elektromagnetischen Gegenfelds einbezieht.

9. Drahtloser Telefon-Hör-/Sprechapparat nach Anspruch 1, **dadurch gekennzeichnet, dass** das Abschirmelement (100) einen Verbund aus elektrisch leitendem Material (101) und magnetisch leitendem Material (102) enthält.

10. Drahtloser Telefon-Hör-/Sprechapparat nach Anspruch 9, **dadurch gekennzeichnet, dass** das Abschirmelement (100) einen Verbund aus elektrisch leitendem und magnetisch leitendem Blech (101, 102) enthält.

11. Drahtloser Telefon-Hör-/Sprechapparat nach Anspruch 1, 9, oder 10, **dadurch gekennzeichnet, dass** das Abschirmelement (100) MU-Blech enthält.

12. Drahtloser Telefon-Hör-/Sprechapparat nach Anspruch 11, **dadurch gekennzeichnet, dass** das MU-Blech mit einer elektrisch leitenden Metallbeschichtung versehen ist.

13. Drahtloser Telefon-Hör-/Sprechapparat nach einem der Ansprüche 1 und 9 bis 13, 5, **dadurch gekennzeichnet, dass** das Abschirmelement (100) massives Abschirmmaterial umfasst.

14. Drahtloser Telefon-Hör-/Sprechapparat nach einem der Ansprüche 1 und 9 bis 13, **dadurch gekennzeichnet, dass** das Abschirmelement (100) netzartig bzw. perforiert ausgebildet ist.

15. Drahtloser Telefon-Hör-/Sprechapparat nach einem der Ansprüche 1 und 9 bis 14, **dadurch gekennzeichnet, dass** das Abschirmelement (100) im Bereich von elektromagnetische Strahlung emittierenden Apparatebestandteilen angeordnet ist.

16. Drahtloser Telefon-Hör-/Sprechapparat nach einem der Ansprüche 1 und 9 bis 14, **dadurch gekennzeichnet, dass** das Abschirmelement (100) sich über die volle Fläche der Oberschale (12, 22) und/oder die Unterschale (21) bis auf Durchbrüche in diesen Apparateteilen erstreckt.

17. Drahtloser Telefon-Hör-/Sprechapparat nach einem der Ansprüche 1 und 9 bis 16, **dadurch gekennzeichnet, dass** das Abschirmelement (100) sich auch über den zurückspringenden Rand der Oberschale (12, 22) bzw. der Unterschale (21) erstreckt.

18. Drahtloser Telefon-Hör-/Sprechapparat nach einem der Ansprüche 1 und 9 bis 17, **dadurch gekennzeichnet, dass** die Oberschale (12, 22) bzw. die Unterschale (21) aus dem Material des Abschirmelements (100) besteht bzw. bestehen.

19. Drahtloser Telefon-Hör-/Sprechapparat nach einem der Ansprüche 1 und 9 bis 18, mit einem über die Oberschale (12, 22) bzw. die Unterschale (21) vorstehenden, beispielsweise mit Kunststoff verkleideten Antennenelement, **dadurch gekennzeichnet, dass** die Verkleidung (17) des Antennenelements Abschirmmaterial des Abschirmelements (100) umfasst, das den gegebenenfalls aus dem Gehäuse herausragenden Antennenstummel kopfseitig soweit abdeckt, dass kopf abgewandt die Antennenfunktion gewährleistet ist.

20. Drahtloser Telefon-Hör-/Sprechapparat nach einem der Ansprüche 1 und 9 bis 19, mit einer vollständig im Gehäuse angeordneten Antenne, **dadurch gekennzeichnet, dass** das Abschirmelement (100) sich im Bereich der Antenne zur EMV-Abschirmung des Kopfes eines Nutzers erstreckt und die Antenne kopfseitig soweit abdeckt, dass kopfabgewandt die Antennenfunktion gewährleistet ist.

## Claims

1. Wireless telephone handset, in particular radio telephone or mobile telephone (10), cordless telephone (20) or the like, having an upper shell (12, 22) which contains apertures for operating elements (13, 23), having a lower shell (21) and having an electrically conductive shielding element (100) for shielding off EMI radiation generated by electronics of this apparatus, **characterized in that** the shielding element (100) is additionally magnetically conductive in order to shield off HF and/or LF radiation, and **in that** at least one device (27) for the application of an opposing field having low- and/or high-frequency field components is provided for the at least partial extinguishment of the field generated by the electronics of the apparatus at the shielding element (100), in order additionally to reduce the field component of the handset energy emitted in the direction of the head of a user.

2. Wireless telephone handset according to Claim 1, **characterized in that** the device (27) comprises a signal registering generation and supply unit for generating an opposing electromagnetic field, which is coupled on one or both sides to the Mumetal sheet via at least one insulated λ/x miniature dipole antenna (28); x is a whole positive number.

3. Wireless telephone handset according to Claim 1 or 2, **characterized in that** the device comprises a measurement and control loop containing the X/x miniature dipole antenna (28) having a probe or antenna for measuring the resultant total electromagnetic field generated by the electronics of the apparatus and facing the head.

4. Wireless telephone handset according to Claim 2 or 3, **characterized in that** the signal generation and supply unit is linked to the measurement and control loop via a signal processor unit.

5. Wireless telephone handset according to Claim 4, **characterized in that** the linking of the two units comprises means for extremely high-frequency signal/phase synchronization.

6. Wireless telephone handset according to Claim 5, **characterized in that** the means for signal packet/phase synchronization provides a phase rotation of the extremely high-frequency signals through 180 degrees for the opposing field.

7. Wireless telephone handset according to one of Claims 2 to 6, **characterized in that** the control device (27) takes the Mumetal sheet into account as a large-area transmission antenna during the production of the opposing electromagnetic field.

8. Wireless telephone handset according to Claim 6, **characterized in that**, in addition to the large-area antenna, the device (27) also incorporates the X/x miniature dipole antenna (28) with, if appropriate, a large number of such dipole antennas, in the generation of the opposing electromagnetic field.

9. Wireless telephone handset according to Claim 1, **characterized in that** the shielding element (100) contains a composite of electrically conductive material (101) and magnetically conductive material (102).

10. Wireless telephone handset according to Claim 9, **characterized in that** the shielding element (100) contains a composite of electrically conductive and magnetically conductive sheet metal (101, 102).

11. Wireless telephone handset according to Claim 1, 9 or 10, **characterized in that** the shielding element (100) contains Mumetal sheet.

12. Wireless telephone handset according to Claim 11, **characterized in that** the Mumetal sheet is provided with an electrically conductive metal coating.

13. Wireless telephone handset according to one of Claims 1 and 9 to 13, 5, **characterized in that** the shielding element (100) comprises solid shielding material.

14. Wireless telephone handset according to one of Claims 1 and 9 to 13, **characterized in that** the shielding element (100) is mesh-like or perforated.

15. Wireless telephone handset according to one of Claims 1 and 9 to 14, **characterized in that** the shielding element (100) is arranged in the region of apparatus constituents emitting electromagnetic radiation.

16. Wireless telephone handset according to one of Claims 1 and 9 to 14, **characterized in that** the shielding element (100) extends over the complete area of the upper shell (12, 22) and/or the lower shell (21), apart from apertures in these apparatus parts.

17. Wireless telephone handset according to one of Claims 1 and 9 to 16, **characterized in that** the shielding element (100) also extends over the turned-back edge of the upper shell (12, 22) and the lower shell (21).

18. Wireless telephone handset according to one of Claims 1 and 9 to 17, **characterized in that** the upper shell (12, 22) and/or the lower shell (21) consist/s of the material of the shielding element (100).

19. Wireless telephone handset according to one of Claims 1 and 9 to 18, having an antenna element which projects beyond the upper shell (12, 22) and the lower shell (21) and is clad with plastic, for example, **characterized in that** the cladding (17) of the antenna element comprises shielding material of the shielding element (100), which covers the stump of the antenna possibly projecting from the housing on the head side to such an extent that the antenna function facing away from the head is ensured.

20. Wireless telephone handset according to one of Claims 1 and 9 to 19, having an antenna arranged completely in the housing, **characterized in that** the shielding element (100) extends in the region of the antenna for the purpose of EMI shielding of the head of a user, and covers the antenna on the head side to such an extent that the antenna function facing away from the head is ensured.

## Revendications

1. Appareil sans fil pour parler, écouter, téléphoner, en particulier radiotéléphone ou téléphone portable (10), téléphone sans fil (20) ou similaire, comprenant une coque supérieure (12, 22) qui contient des passages pour des éléments de commande (13, 23), une coque inférieure (21) et un élément de blindage (100) électriquement conducteur pour la protection contre le rayonnement de compatibilité électromagnétique (rayonnement EMC) généré par l'électronique de cet appareil, **caractérisé en ce que** l'élément de blindage (100) est également magnétiquement conducteur pour la protection contre le rayonnement HF et/ou le rayonnement BF, et
**en ce qu'**au moins un dispositif (27) est prévu pour l'application d'un contre-champ avec des parties de champ à basse fréquence et/ou à haute fréquence pour la suppression au moins partielle du champ généré par l'électronique de l'appareil sur l'élément de blindage (100), afin de réduire davantage la part de champ du rayonnement d'énergie de l'appareil téléphonique en direction de la tête d'un utilisateur.

2. Appareil sans fil pour parler, écouter, téléphoner selon la revendication 1, **caractérisé en ce que** le dispositif (27) comprend une unité de production et d'alimentation d'enregistrement de signal pour générer un contre-champ électromagnétique, qui est couplé sur un côté ou sur deux côtés au moyen d'au moins une antenne dipôle miniature λ/x (28) isolée à la tôle métallique MU, x étant un nombre positif entier.

3. Appareil sans fil pour parler, écouter, téléphoner selon la revendication 1 ou 2, **caractérisé en ce que** le dispositif comprend une boucle de mesure et de réglage contenant une antenne dipôle miniature λ/x (28) avec une sonde ou une antenne pour la mesure du champ global électromagnétique résultant dirigé vers la tête générée par l'électronique de l'appareil.

4. Appareil sans fil pour parler, écouter, téléphoner selon la revendication 2 ou 3, **caractérisé en ce que** l'unité de production et d'alimentation de signal est associée avec la boucle de mesure et de réglage au moyen d'une unité de processeur de signal.

5. Appareil sans fil pour parler, écouter, téléphoner selon la revendication 4, **caractérisé en ce que** l'association des deux unités comprend un moyen pour la synchronisation de signal et de phase à fréquence très élevée.

6. Appareil sans fil pour parler, écouter, téléphoner selon la revendication 5, **caractérisé en ce que** les moyens pour la synchronisation du paquet de signal/de phase met à disposition une rotation de phase des signaux à fréquence très élevée de 180° pour le contre-champ.

7. Appareil sans fil pour parler, écouter, téléphoner selon l'une quelconque des revendications 2 à 6, **caractérisé en ce que** le dispositif de commande (27) prend en compte la tôle métallique MU en tant qu'antennes d'émission de grande surface pour la production du contre-champ électromagnétique.

8. Appareil sans fil pour parler, écouter, téléphoner selon la revendication 6, **caractérisé en ce que** le dispositif (27) intègre, en plus de l'antenne à grande surface, l'antenne dipôle miniature λ/x (28) à éventuellement une pluralité d'antennes dipôles de ce type pour la production du contre-champ électromagnétique.

9. Appareil sans fil pour parler, écouter, téléphoner selon la revendication 1, **caractérisé en ce que** l'élément de blindage (100) contient un composite à base de matériau (101) électriquement conducteur et de matériau (102) magnétiquement conducteur.

10. Appareil sans fil pour parler, écouter, téléphoner selon la revendication 9, **caractérisé en ce que** l'élément de blindage (100) contient un composite à base de tôle (101, 102) électriquement conducteur et magnétiquement conducteur.

11. Appareil sans fil pour parler, écouter, téléphoner selon la revendication 1, 9 ou 10, **caractérisé en ce que** l'élément de blindage (100) contient de la tôle MU.

12. Appareil sans fil pour parler, écouter, téléphoner selon la revendication 11, **caractérisé en ce que** la tôle MU est dotée d'un revêtement métallique électriquement conducteur.

13. Appareil sans fil pour parler, écouter, téléphoner selon l'une quelconque des revendications 1 et 9 à 12, **caractérisé en ce que** l'élément de blindage (100) contient du matériau de blindage massif.

14. Appareil sans fil pour parler, écouter, téléphoner selon l'une quelconque des revendications 1 et 9 à 13, **caractérisé en ce que** l'élément de blindage (100) est conçu à la façon d'un treillis, respectivement de manière perforée.

15. Appareil sans fil pour parler, écouter, téléphoner selon l'une quelconque des revendications 1 et 9 à 14, **caractérisé en ce que** l'élément de blindage (100) est disposé dans la zone de composants d'appareil émettant du rayonnement électromagnétique.

16. Appareil sans fil pour parler, écouter, téléphoner selon l'une quelconque des revendications 1 et 9 à 14, **caractérisé en ce que** l'élément de blindage (100) s'étend sur toute la surface de la coque supérieure (12, 22) et/ou la coque inférieure (21) à l'exception de passages dans ces parties d'appareils.

17. Appareil sans fil pour parler, écouter, téléphoner selon l'une quelconque des revendications 1 et 9 à 16, **caractérisé en ce que** l'élément de blindage (100) s'étend également sur le bord de la coque supérieure (12, 22) ou de la coque inférieure (21).

18. Appareil sans fil pour parler, écouter, téléphoner selon l'une quelconque des revendications 1 et 9 à 17, **caractérisé en ce que** la coque supérieure (12, 22) et/ou la coque inférieure (21) est/sont à base du matériau de l'élément de blindage (100).

19. Appareil sans fil pour parler, écouter, téléphoner selon l'une quelconque des revendications 1 et 9 à 18, comprenant un élément d'antenne qui fait saillie au-delà de la coque supérieure (12, 22) ou de la coque inférieure (21), revêtu par exemple avec du plastique, **caractérisé en ce que** le revêtement (17) de l'élément d'antenne comprend du matériau de blindage de l'élément de blindage (100), qui recouvre côté tête le bout d'antenne dépassant éventuellement du boîtier dans une mesure telle que la fonction d'antenne est garantie côté opposé à la tête.

20. Appareil sans fil pour parler, écouter, téléphoner selon l'une quelconque des revendications 1 et 9 à 19, comprenant une antenne disposée complètement dans le boîtier, **caractérisé en ce que** l'élément de blindage (100) s'étend dans la zone de l'antenne pour le blindage EMC de la tête d'un utilisateur et recouvre l'antenne côté tête dans une mesure telle que la fonction d'antenne est garantie côté opposé à la tête.
